# EUROPEAN PATENT APPLICATION

(11) **EP 1 830 620 A1**
(43) Date of publication of application: **05.09.2007**
(21) Application number: 06110649.8
(22) Date of filing: 03.03.2006
(51) Int. Cl.: H05K 7/10, H01R 13/24, H01R 12/22

(54) **Elastomeric connector**

(71) Applicant: Lih Duo International Co., Ltd., Wu Gu Shiang, Taipei Hsien (TW)
(72) Inventor: Wang, Sung-Lai, Wu Gu Shiang, Taipei Hsien (TW)
(74) Representative: Beck, Michael Rudolf

(57) **Abstract**

An elastomeric connector (20) has effects of electric current conduction and position alignment for aligning an electronic part to be connected in desired position, which comprises an insulating base board (21) having a plurality of inserting holes (22) arranged in matrix form of longitudinal columns and transverse rows, each inserting hole (22) having a corresponding electric conducting spring (30) fixed therein, wherein the insulating hole (22) is formed by two holes shaped in frustum of cone with the small top sides connected to each other to have a narrowest throat portion (23) formed inside and adapted to grip the corresponding electric conducting spring (30) at the middle portion and keep both ends of the electric conducting spring (30) in the condition able to move freely.

## Description

### BACKGROUND OF THE INVENTION

### 1. Field of the Invention

The invention relates to an elastomeric connector, especially to an elastomeric connector having effects of electric current conduction and position alignment for an electronic part to be connected.

### 2. Description of the Prior Art

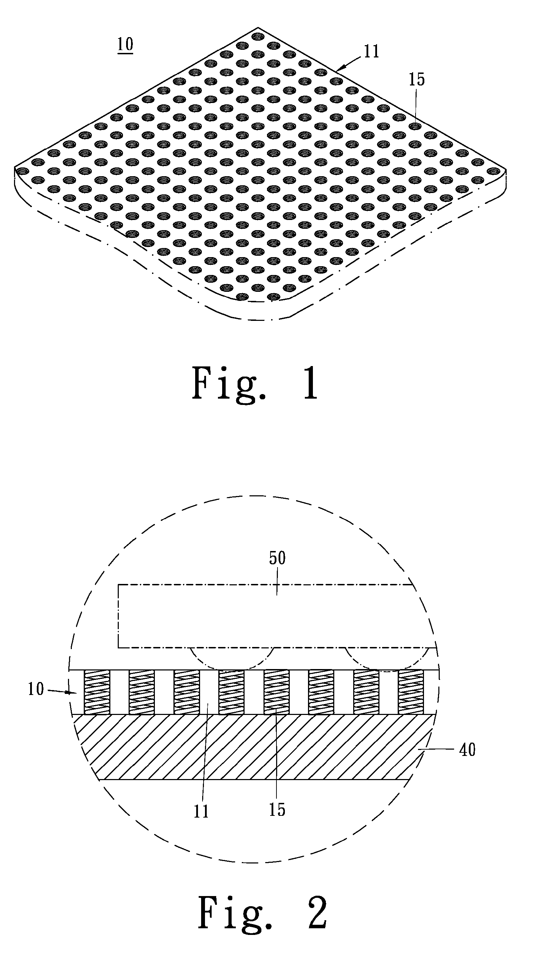

Shown in Fig. 1 is a prior used rubber connector 10 which comprises an insulating soft silicon rubber sheet 11 and a plurality of electric conducting springs 15 installed inside the silicon rubber sheet 11 and arranged in matrix form of longitudinal columns and transverse rows.

In addition to being used as connector, the feature of the rubber connector 10 also includes the effect of elastic cushion, i.e. when the insulating silicon rubber sheet 11 is hit by an object or acted by a shock, it can immediately spring back to restore its shape after the external force due to hitting by other object or shock disappears. This has made the rubber connector 10 to posses the advantage of high working durability and long service life.

The rubber connector 10 can be used for connecting the disconnected or separated electric circuit and allowing current to flow through the circuit. As shown in Fig. 2, the printed circuit board 40 and electronic part 50 are connected by the rubber connector 10 to form electric connection, and, by employing the cushion effect of the conducting spring group 15, a stable and reliable electric connection between the printed circuit board 40 and the electronic part 50 can be attended to achieve the desired function.

However, the electric conducting spring group 15 formed on the rubber connector 10 must be completely wrapped with the insulating soft silicon rubber sheet 11 so that the electric conducting spring group 15 arranged in matrix form can be protected by the insulating soft silicon rubber sheet 11. Owing to this structure, the drawback of the rubber connector 10 is that both ends of the electric conducting spring of the conducting spring group 15 are constrained and are unable to move freely. This has caused the limitation of application of the rubber connector 10. Besides, the rubber connector 10 possesses no any other function of application except the effect of electric connection.

### SUMMARY OF THE INVENTION

The major purpose of the invention is to disclose an elastomeric connector used for connecting the disconnected or separated circuit to allow current flowing through the circuit, which elastomeric connector has both effects of electric current conduction and position alignment for aligning the position of electronic part having tin balls on the bottom side and fixing it in the desired position.

The structure of elastomeric connector of the invention comprises an insulating base board and a group of electric conducting springs installed on the insulating base board arranged in matrix form of longitudinal columns and transverse rows.

The insulating base board has a plurality of inserting holes arranged in matrix form of longitudinal columns and transverse rows and each insulating holes is formed by two holes shaped in frustum of cone with small top side connected to each other to have a narrowest throat portion formed inside the inserting hole; each insulating holes has a corresponding electric conducting spring fixed inside by having it middle portion tightly griped by the narrowest throat portion of the inserting hole to enable both ends of the electric conducting spring to be formed as a pair of separated connecting terminals which are stretched out from both sides of the insulating base board and able to move freely into the inserting hole respectively to further broaden the scope of application of the elastomeric connector.

### BRIEF DESCRIPTION OF THE DRAWINGS

Fig. 1 is an enlarged structural drawing of the prior used rubber connector.
Fig. 2 is a schematic drawing to show the application of the rubber connector shown in Fig. 1.
Fig. 3 is an enlarged structural drawing of the invented elastomeric connector of the invention.
Fig. 4 is a structural drawing of the invented elastomeric connector whose inserting hole has an electric conducting spring fixed inside by having its middle portion griped by the narrowest portion of the inserting hole.
Fig. 5 is a schematic drawing to illustrate the invented elastomeric connector of the invention is adapted to form an electric connection between an electronic part and a printed circuit board and has the effect of position alignment to hold the electric part in desired position through a plurality of tin balls formed on bottom side of the electric part.
Fig. 6 is a schematic drawing to illustrate the invented elastomeric connector of the invention is adapted to form an electric connection between an electronic part having connecting terminals formed on its bottom and a printed circuit board.
Fig. 7 is a schematic drawing to illustrate the invented elastomeric connector of the invention is also adapted to form an electric connection between a special electric part and a printed circuit and has the effect of position alignment to hold the special electric part in desired position through a plurality of tin balls and connecting terminals together formed on bottom side of the special electric part.
Fig. 8 is another embodiment of the elastomeric connector of the invention whose inserting hole has protruding block formed on its inner wall for fixing an electric conducting spring inside through its middle portion of the electric conducting spring.

### DESCRIPTION OF THE PREFERRED EMBODIMENT

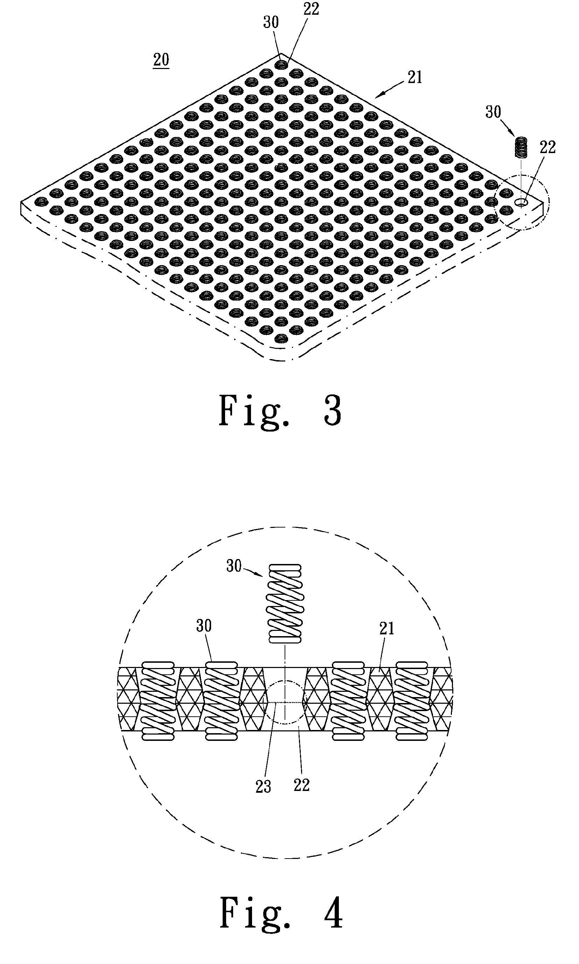

As shown in Fig. 3, an elastomeric connector 20 of the invention has an insulating base board 21 which has a plurality of inserting holes 22 arranged in matrix form of longitudinal columns and transverse rows. Each of the inserting holes 22 has an electric conducting spring 30 which is fixed inside the inserting hole 22 through its middle portion, so that both ends of the electric conducting spring 30 shall stretch out from both sides of the insulating base board 21, and shall be in a condition able to move freely to form an electric conducting terminal located on both sides of the insulating base board 21.

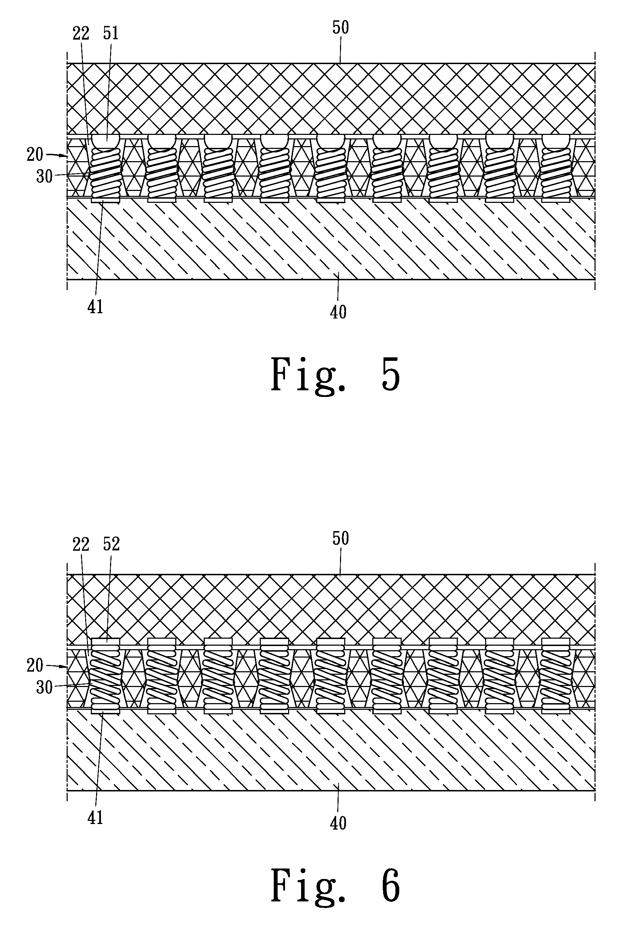

As shown in Fig. 3 and 4, the structure of the inserting hole 22 on the insulating base board 21 is shaped with a narrowest throat portion 23 having the smallest internal diameter formed inside and along the center line of the inserting hole 22, and the opening of the inserting hole 22 formed on the surface of both sides of the insulating base board 21 has the largest internal diameter, i.e. the inserting hole 22 has a structure formed by two holes shaped in frustum of cone with small top side connected to each other, so that the connecting portion forms the throat portion 23 having the smallest internal diameter of the inserting hole 22.

The internal diameter of the throat portion 23 of the inserting hole 22 is a little smaller than the outside diameter of the middle portion of the electric conducting spring 30, so that the electric conducting spring 30 can be installed in the inserting hole 22 with the middle portion tightly griped by the throat portion 23 that can prevent separation of the electric conducting spring 30 from the insulating base board 21 while both ends of the insulating spring 30 can be kept in the condition able to move freely.

Further, by inserting a corresponding electric conducting spring 30 into each inserting holes 22 of the insulating base board 21, a spring matrix having a group of electric conducting springs 30 arranged in longitudinal columns and transverse rows is then formed on the insulating base board 21, and both ends of each electric conducting springs 30 shall be stretched out from both sides of the insulating base board 21 to form a pair of separated connecting terminals and have the effect of electric current conduction and elastic position alignment for connecting the disconnected or separated circuit to allow current flowing through the circuit.

As shown in Figs. 5 to 7, the elastomeric connector 20 of the invention can be applied for an electronic part 50 which has tin balls 51 and/or electric connecting terminal 52 on its bottom side, when the elastomeric connector 20 of the invention is employed between the electronic part 50 and a printed circuit board 40 having electric circuit connecting terminal 41 to form an electric connection, the connecting terminal formed by the end portion of the electric conducting spring 30 and stretched out from both sides of the insulating base board 21 can achieve a tight contact with the electric circuit connecting terminal 41 of the printed circuit board 40 and the tin balls 51 and/or the connecting terminal 52 on the bottom side of the electronic part 50 to achieve a stable and reliable electric connection between the printed circuit board 40 and the electronic part 50 as well as the desired function between them.

Particularly, in addition to the purpose of having the inserting hole 22 of the insulating base board 21 formed into the shape of frustum of cone as mentioned above is to maintain a free movement of the end portion of the electric conducting spring 30, another purpose is to provide position alignment effect to the electronic part 50 having tin balls 51 on its bottom side.

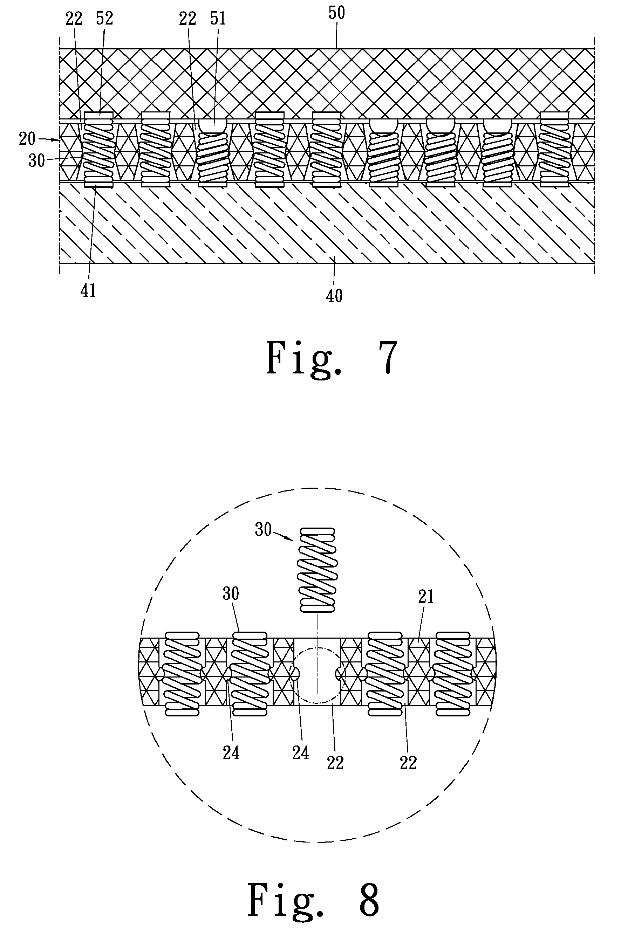

An example is shown in Fig. 5 and 7, when the electronic part 50 having tin balls 51 formed on its bottom side and the elastomeric connector 20 of the invention are assembled together to form an electric connection, the space formed in shape of frustum of cone of the inserting hole 22 formed on the insulating base board 21 can accommodate the tin balls 51 of the electronic part 50 that attains the effect of position alignment to hold the electronic part 50 in the desired position.

Shown in Fig. 8 is another embodiment of the elastomeric connector 20 of the invention which has protruding blocks 24 formed on the inner wall surface of the inserting hole 22 for fixing the electric conducting spring 30 in the inserting hole 22 by having the electric conducting spring 30 gripped by the protruding blocks 24 through its middle point to prevent separation of the electric conducting spring 30 from the inserting hole 22 while the end portion of the electric conducting spring 30 is still in the condition able to move freely, and the insulating base board 21 having inserting holes 22 with this kind of structure can also provide position alignment effect to the electronic part 50 having tin balls 51and/or electric connecting terminal 52.

## Claims

1. An elastomeric connector comprising an insulating base board (21) and a group of electric conducting springs (30) fixed on the insulating base board (21), **characterized in that** the insulating base board (21) has a plurality of inserting holes (22) arranged in matrix form of longitudinal columns and transverse rows, each inserting hole (22) having a corresponding electric conducting spring (30) fixed therein, wherein the insulating hole (22) is formed by two holes shaped in frustum of cone with the small top sides connected to each other to have a narrowest throat portion (23) formed inside and adapted to grip the corresponding electric conducting spring (30) at the middle portion and keep both ends of the electric conducting spring (30) in the condition able to move freely.

2. An elastomeric connector comprising an insulating base board (21) and a group of electric conducting springs (30) fixed on the insulating base board (21), **characterized in that** the insulating base board (21) has a plurality of inserting holes (22) arranged in matrix form of longitudinal columns and transverse rows, each inserting hole (22) having a corresponding electric conducting spring (30) fixed therein, wherein the inserting hole (22) has protruding blocks (24) formed on inner wall and adapted to grip the corresponding electric conducting spring (30) at the middle portion and keep both ends of the electric conducting spring (30) in the condition able to move freely.
